# EUROPEAN PATENT SPECIFICATION

(11) **EP 3 245 659 B1**
(45) Date of publication and mention of the grant of the patent: **06.03.2019**
(21) Application number: 15738130.2
(22) Date of filing: 18.06.2015
(51) Int. Cl.: H01F 7/02, H01F 7/04, B25B 11/00, G01D 5/14, G01R 33/07, G01R 33/09

(54) **MAGNET**
MAGNET
AIMANT

(30) Priority: 12.01.2015 WO PCT/FI2015/050014; 14.01.2015 WO PCT/FI2015/050019
(43) Date of publication of application: 22.11.2017
(73) Proprietor: Ixtur OY, 21500 Piikkiö (FI)
(72) Inventor: RINKINEN, Topi, FI-10210 Inkoo (FI); SUOMINEN, Juho, FI-20750 Turku (FI); NÄTTI, Reijo, FI-20660 Littoinen (FI)
(74) Representative: Berggren Oy, Turku
(86) International application number: PCT/FI2015/050449
(87) International publication number: WO 2016/113457

(56) References cited:
- WO-A1-2012/160262
- DE-A1- 19 951 703
- US-A1- 2012 153 649

## Description

### TECHNICAL FIELD OF THE INVENTION

The present invention relates to a magnet according to the preamble of the appended independent claim.

### BACKGROUND OF THE INVENTION

Magnets that comprise a movable part for changing the magnetic state of the magnet are known in the prior art. An example of such a magnet is disclosed in the document WO 2012/160262. The magnet of the document WO 2012/160262 is a so-called bi-stable magnet, wherein the movable part, which comprises a permanent magnet, is arranged to be movable relative to a body of the magnet between two stable positions. In the first position, the movable part is separated from the body so that in the body the magnetic flux generated by the permanent magnet is low and thus the holding force of the magnet is negligible. In the second position, the movable part is in contact with the body, whereby the magnetic flux generated by the permanent magnet may be directed through the body to an object to be attached. The body of the magnet comprises a coil that is arranged around the movable part. The movable part is moved between the two positions by supplying a sufficient amount of electric current through the coil in a suitable direction.

A problem associated with the magnet of the document WO 2012/160262 is that the length of the movement of the movable part is large, as a result of which the magnet is tall. Because of the structure of the magnet, the distance between the first and second positions of the movable part needs to be large so that the movable part can be easily held in place in its first position. The larger the distance between the first and second positions, the smaller the force that is needed to keep the movable part in the first position. In the magnet of the document WO 2012/160262, the movable part is held in place in its first position using a coil that is supplied with an electric current or using springs that push the movable part towards the first position. A disadvantage of the coil is that it consumes energy, whereas a disadvantage of the springs is the complicated structure, which may be damaged easily. US2012/0153649 discloses a magnetic workpiece handling device, having a housing and a housing bottom. The magnetic slide is kept in the inactive position by a resilient elastic member.

### OBJECTIVES OF THE INVENTION

It is the main objective of the present invention to reduce or even eliminate the prior art problems presented above.

It is an objective of the present invention to provide a magnet having a structure that enables to achieve a large holding force with a small size. It is also an objective of the invention to provide a magnet comprising a movable part for changing the magnetic state of the magnet, wherein the length of the movement of the movable part is small.

It is a further objective of the present invention to provide a magnet that has stable magnetic states at which the magnet does not consume energy. It is also an objective of the invention to provide a magnet, whose magnetic state can be changed easily using very little energy.

It is still a further objective of the invention to provide a magnet that has a simple structure, low manufacturing costs, a long life expectancy and a great reliability.

In order to realise the above-mentioned objectives, the magnet according to the invention is characterised by what is presented in the characterising part of the appended independent claim. Advantageous embodiments of the invention are described in the dependent claims.

### DESCRIPTION OF THE INVENTION

A typical magnet according to the invention comprises:
- a body that comprises a first and a second section made of magnetic material for directing magnetic flux to an object to be attached, the first and the second section being separated and attached to a third section of the body, which third section is made of non-magnetic material, and
- a slide that comprises a permanent magnet, and a first and a second pole piece attached to opposite magnetic pole surfaces of the permanent magnet, the slide being arranged to be movable relative to the body between a first and a second position in order to alter the path of the magnetic flux generated by the permanent magnet.

In a typical magnet according to the invention:
- the first section comprises a hole that opens at its first end into a cavity of the body, the bottom of the cavity being defined at least partly by the second section, in which hole the slide is movably arranged so that at least part of the first pole piece stays inside the hole and the second pole piece is directed towards the bottom of the cavity,
wherein the movement of the slide is limited by the first and the second section in such a manner that at the first position of the slide, the second pole piece is in contact with the first section, and at the second position of the slide, the second pole piece is in contact with the second section.

The magnet according to the invention is an attachment magnet, the magnetic state of which can be changed by moving the slide relative to the body between the first and the second position. At the first position of the slide (OFF state), the magnetic flux generated by the permanent magnet is essentially short-circuited by the first section, and therefore the magnet cannot attach to an object or it can attach to an object only very weakly. At the second position of the slide (ON state), the magnetic flux is conducted through the first and the second section to an object that is arranged in contact with the first and the second section. The object closes the magnetic circuit and therefore the magnet is attached to the object. The first and the second position are stable positions at which the slide tends to stay still with the help of the magnetic field produced by the permanent magnet.

At the first position of the slide, the second pole piece is in contact with the first section and at least part of the first pole piece is located inside the hole of the first section. Preferably, the first pole piece is in contact or nearly in contact with the wall of the hole. Preferably, at the first position of the slide, the first pole piece is located completely and the permanent magnet at least partly inside the hole. Preferably, at the first position of the slide, the second pole piece is located outside the hole.

When the slide is at the first position, the magnetic flux generated by the permanent magnet is essentially short-circuited by the first section, which means that the magnetic flux flows from one pole piece to the other mainly through the part of the first section that surrounds the hole and the part of the first section that is in contact with the second pole piece. The first position of the slide is a position to which the magnetic force of the permanent magnet actively pulls the slide when the slide is close to the first position. When the slide is moved away from the first position towards the second position, the permanent magnet produces a counterforce that works against the moving force and tries to pull the slide back to the first position.

At the second position of the slide, the second pole piece is in contact with the second section and at least part of the first pole piece is located inside the hole. Preferably, the first pole piece is in contact or nearly in contact with the wall of the hole. At the second position of the slide, the second pole piece and preferably also the permanent magnet are located outside the hole.

When the slide is at the second position, the magnetic flux generated by the permanent magnet may flow through the first and the second section to an object to be attached. The object that is arranged in contact with both the first and the second section closes the magnetic circuit, whereby magnetic flux is conducted from one pole piece to the other through the first and the second section and the object.

The first and the second section of the body are separated from each other by the third section. Because the third section is made of non-magnetic material, the first and the second section are magnetically separated, so that the flow of the magnetic flux directly between the first and the second section is essentially prevented.

The slide is movably arranged in the hole of the first section in such a manner that part of the first pole piece always stays inside the hole. The slide is arranged to be linearly movable between the first and the second position, in the longitudinal direction of the hole. The slide can be designed to be moved between the first and the second position manually, for example with a shaft attached to the slide, or with the help of suitable driving means.

The movement of the slide is mechanically limited by the first and the second section of the body in such a manner that in a first direction the movement of the slide is stopped by the engagement of the second pole piece with the first section, and in a second direction by the engagement of the second pole piece with the second section. Thus, at the first position of the slide the second pole piece is in contact with the first section, and at the second position of the slide the second pole piece is in contact with the second section. The contact surface between the second pole piece and the first section may have different shapes and orientations. The contact surface can have, for example, the shape of an annulus or a truncated cone.

The movement of the slide is mechanically supported by the wall of the hole. Preferably, the slide stays in contact with the wall of the hole in all positions of the slide.

The first end of the hole opens into the cavity of the body. A second end of the hole can be closed or open. The second end of the hole can be closed by the first section or a fourth section that is attached to the first section.

The sections of the body may have various shapes and sizes, and they can be formed of one or more parts. The first, the second and the third section can be arranged within each other in such a manner that the first section surrounds the third section, which surrounds the second section. The third section can be a sleeve that is arranged around the second section. The second section can be a cylinder that is arranged inside the third section. The first and the second section are made of magnetic material that is suitable for conducting magnetic flux. Magnetic material of the first and the second section is ferromagnetic material, such as iron, nickel, cobalt or their alloys. The first section and the second section are preferably made of the same material. The third section is made of non-magnetic material, which can be paramagnetic material, such as resin, brass or aluminium, or diamagnetic material, such as acid-proof steel or stainless steel.

The slide has a sandwich structure, wherein the permanent magnet is arranged between the first and the second pole piece. The first pole piece and the second pole piece are attached to different poles of the permanent magnet and are made of magnetic material so that the magnetic flux generated by the permanent magnet may be conducted through them. Magnetic material of the first and the second pole piece is ferromagnetic material, preferably iron. The permanent magnet can be, for example, a neodymium magnet, an alnico magnet or a samarium-cobalt magnet.

The magnet according to the invention is suitable for moving objects and can thus be used as a lifting magnet. The magnet can be used as follows to move an object from one location to another. First, the magnet is arranged in contact with an object in such a manner that the object is in contact with the attachment surfaces of the first and the second section. Then, the slide is moved to the second position as a result of which the magnet is attached to the object. Next, the object is moved with the magnet to a desired location and the magnet is detached from the object by moving the slide to the first position.

According to an embodiment of the invention the diameter of the second pole piece is larger than the diameter of the hole. Because the diameter of the second pole piece is larger than the diameter of the hole, the second pole piece stays outside the hole and thus inside the cavity in all positions of the slide.

According to an embodiment of the invention the hole and the first pole piece are cylindrical. Preferably, the diameter of the first pole piece is only slightly smaller than the diameter of the hole, whereby the wall of the hole can efficiently support the slide while the slide is moved between the first and the second position. The diameter of the hole can be, for example, less than 10 mm, 10-50 mm, 50-200 mm or 200-500 mm. The diameter of the first pole piece can be, for example, less than 2 mm, less than 1 mm, less than 0.5 mm, less than 0.1 mm, less than 0.01 mm or 0.005-0.5 mm smaller than the diameter of the hole.

According to an embodiment of the invention the second pole piece is cylindrical. The diameter of the second pole piece is larger than the diameter of the first pole piece and the diameter of the hole.

According to an embodiment of the invention the cavity is cylindrical. The diameter of the cavity is larger than the diameter of the hole of the first section. The diameter of the cavity can be, for example, 1-5 mm, 2-10 mm, 5-50 mm or 25-300 mm larger than the diameter of the hole.

According to an embodiment of the invention the height of the slide is larger than the height of the hole. The height of the slide can be, for example, less than 3 mm, 3-10 mm, 10-100 mm or 100-500 mm. The height of the slide can be, for example, 1-5 mm, 2-10 mm, 5-50 mm or 25-100 mm larger than the height of the hole.

According to an embodiment of the invention the permanent magnet comprises a plurality of magnet pieces arranged in one or more layers. The permanent magnet can, for example, be formed of sector pieces arranged in one layer in such a manner that the same poles of the sector pieces are disposed on the same side of the permanent magnet. The number of sector pieces can be, for example, 2, 3, 4-6 or 7-10. The permanent magnet can alternatively be formed of magnet pieces arranged one on the other. The magnet pieces can be arranged one on the other in such a manner that ferromagnetic discs are arranged between the magnet pieces and the different poles of the magnet pieces are arranged to face each other.

According to an embodiment of the invention the thickness of the permanent magnet is smaller than the thickness of the first pole piece and the thickness of the second pole piece. The use of thicker pole pieces prevents the magnetic flux from saturating.

According to an embodiment of the invention the permanent magnet is cylindrical and the diameter of the permanent magnet is smaller than the diameter of the first pole piece. The smaller diameter of the permanent magnet prevents the permanent magnet from touching the wall of the hole.

According to an embodiment of the invention the first section defines the wall of the cavity.

According to an embodiment of the invention the third section is a hollow cylinder attached inside the first section, and the second section is attached inside the third section. The second section is preferably cylindrical.

According to an embodiment of the invention the third section defines the wall of the cavity.

According to an embodiment of the invention the first and the second section are plates arranged in parallel to each other. An object to be attached is meant to be in contact with a side of the first plate and a side of the second plate. The slide is arranged to move in a direction perpendicular to the plane of the plates. Preferably, the first and the second plate are rectangular. The thickness of the first and the second plate can be, for example, less than 3 mm, 3-10 mm, 10-100 mm or 100-500 mm. A side of the first and the second plate that is meant to be in contact with an object can be straight, curved or bevelled. Preferably, the side of the first and the second plate that is meant to be in contact with an object is shaped to correspond to the shape of the object.

According to an embodiment of the invention the third section comprises a plurality of connecting members attached between the first and the second section. The number of the connecting members can vary depending on the application. In a case where the first and the second section are plates, a connecting member is preferably attached to each corner of the first and the second plate, whereby if the first and the second plate are rectangular, the body comprises four connecting members. Preferably, the connecting members are rods or bars, whose first ends are attached to the first section, and whose second ends are attached to the second section. The connecting members can be made of paramagnetic material, such as resin, brass or aluminium, or diamagnetic material, such as acid-proof steel or stainless steel.

According to an embodiment of the invention the cavity is defined by the first, the second and the third section. The cavity can be, for example, cylindrical. The third section can comprise a cylindrical through hole that defines the wall of the cavity.

According to an embodiment of the invention a second end of the hole is closed by a fourth section of the body. The fourth section is attached to the first section and it may define a cavity into which the second end of the hole opens. The fourth section can be made of magnetic or non-magnetic material. The fourth section can be made of the same material as the first section. The first section and the fourth section may form an integral structure. This structure can be manufactured from one piece of magnetic material by machining.

According to an embodiment of the invention the magnet comprises means for transferring a medium into and out of the body in order to move the slide. The slide is moved relative to the body by transferring medium that can be gas or liquid into and out of the hole and the cavity. The slide can be moved towards the first position by transferring medium into the cavity and out of the hole. The slide can be moved towards the second position by transferring medium into the hole and out of the cavity. The holding force of the magnet depends on the position of the slide. Because the slide can be positioned to any position between the first and the second position, the holding force of the magnet can be adjusted steplessly. The magnet consumes very little energy for maintaining the holding force constant. The holding force is at its minimum when the slide is at the first position, and at its maximum when the slide is at the second position.

The cavity and the hole can be connected together through the means for transferring the medium, whereby the medium can be transferred from the cavity to the hole, and vice versa. Alternatively, the means for transferring the medium can be arranged to separately control the medium in the cavity and the hole. In this case, the means for transferring the medium can comprise containers for both the cavity and the hole for receiving the medium that has been transferred out of the body.

According to an embodiment of the invention the means for transferring a medium into and out of the body comprises a first and a second conduit integrated into the body, a first end of the first conduit being in communication with the cavity and a first end of the second conduit being in communication with the hole. Medium can be transferred into and out of the cavity and the hole through the first conduit and the second conduit, respectively. Preferably, the first end of the first conduit is arranged to the bottom of the cavity, and the first end of the second conduit is arranged to the second end of the hole. Second ends of the conduits may be in communication with each other so that the medium that has been transferred out of the cavity can be transferred into the hole, and vice versa. The magnet may comprise a plurality of first and second conduits. The number of the first and the second conduits can be, for example, 2-4, 5-10 or 10-30.

According to an embodiment of the invention a second end of the first conduit and a second end of the second conduit open outside the magnet. The first and the second conduit thus extend through the body.

According to an embodiment of the invention the means for transferring a medium into and out of the body comprises a pneumatic or a hydraulic system coupled to the second end of the first conduit and the second end of the second conduit.

According to an embodiment of the invention the means for transferring a medium into and out of the body comprises a pump coupled to the second end of the first conduit and the second end of the second conduit. The pump can be configured to transfer medium in two directions, whereby the medium can be transferred from the cavity into the hole, and vice versa. The means for transferring a medium into and out of the body may comprise two pumps, the first pump being coupled to the second end of the first conduit and the second pump being coupled to the second end of the second conduit. Depending on the type of the medium, the pump can be a hydraulic pump or a pneumatic pump, such as a piston pump, a screw pump or a gear pump. It is also possible to use an existing hydraulic or pneumatic system coupled to the second ends of the conduits for transferring the medium into and out of the body.

According to an embodiment of the invention the means for transferring a medium into and out of the body comprises a first pipe coupled between the pump and the second end of the first conduit, and a second pipe coupled between the pump and the second end of the second conduit.

According to an embodiment of the invention the magnet comprises a medium that is gas or liquid. A suitable gas for the magnet is, for example, air. Suitable liquids for the magnet are, for example, oil and water. Preferably, the liquid that is used also functions as a lubricant, reducing the friction between the slide and the wall of the hole.

According to an embodiment of the invention the magnet comprises a magnetic flux sensor configured to measure magnetic flux density in the first section, and means for determining the position of the slide based on the measured magnetic flux density. By a magnetic flux sensor it is meant a transducer that varies its output voltage and/or output current in response to magnetic flux density. Since the path of the magnetic flux in the first section is dependent on the position of the slide, the position of the slide can be determined from the output voltage and/or the output current of the magnetic flux sensor. The means for determining the position of the slide may comprise, for example, a comparator circuit for providing, as a response to the output voltage and/or the output current of the magnetic flux sensor, an output signal identifying whether the slide is in the first or the second position. The magnetic flux sensor may also be configured to indicate the position of the slide directly as a binary output. The magnetic flux sensor may also be used to detect whether an object is attached to the magnet or not. The magnetic flux sensor can be, for example, arranged inside the first section, or attached on its surface.

The magnet may comprise a plurality of magnetic flux sensors, which are configured to measure magnetic flux densities in different spatial locations and/or directions. The magnetic flux sensors can be configured to measure magnetic flux densities, for example, in orthogonal and/or opposite directions. The number of magnetic flux sensors can be, for example, 2, 3, or more than 3.

According to an embodiment of the invention the magnetic flux sensor is one of the following: a Hall sensor, an AMR magnetometer, a MEMS sensor or a reed relay.

According to an embodiment of the invention the slide comprises a guiding rod extending to a bore in the second section. The guiding rod, which extends in the longitudinal direction of the hole, may be arranged to extend partly or completely through the slide. The guiding rod is preferably dimensioned in such a manner that part of the guiding rod stays in the bore all the time. The purpose of the guiding rod is to reduce the movement of the slide in other directions than the longitudinal direction of the hole. The guiding rod is made of non-magnetic material, which can be paramagnetic material, such as resin, brass or aluminium, or diamagnetic material, such as acid-proof steel or stainless steel.

According to an embodiment of the invention the magnet comprises a coil attached to the body and configured to generate a magnetic force for moving the slide towards the first or the second position depending on the direction of electric current that is supplied to the coil. The coil can be arranged inside the third section in such a manner that the coil encircles the slide at least partly when the slide is at the second position. The position of the slide can be changed with an electric current pulse that has a certain duration, magnitude and polarity. The duration and the magnitude of the electric current pulse that is needed to move the slide from the first position to the second position, and vice versa, are highly dependent on the structure and the size of the magnet. The polarity of the electric current pulse depends on the direction to which the slide needs to be moved. Typically, the duration of the electric current pulse is 30-300 ms. The coil may also be used to increase or decrease the holding force of the magnet depending on the direction of electric current that is supplied to the coil. Preferably, the coil is used to adjust the holding force of the magnet.

According to an embodiment of the invention the magnet comprises means for supplying electric current to the coil. The means for supplying electric current may comprise, for example, a battery that is connected to the coil via a control unit. The control unit is configured to control the amount and the direction of electric current supplied to the coil. The control unit may comprise one or more operating switches for using the magnet, and/or a wireless receiver for receiving control commands from a remote controller. The control unit may also comprise one or more indicator lights for indicating the status of the magnet, and/or a wireless transmitter for transmitting the status information to the remote controller.

According to an embodiment of the invention the magnet comprises a sealing ring installed around the slide or attached to the wall of the hole. Preferably, the sealing ring is installed around the first pole piece. The sealing ring divides an airtight space formed inside the body into two portions and prevents the medium from flowing between said portions. The sealing ring makes it easier to create a sufficient pressure difference and enables moving the slide efficiently. The sealing ring can be made of, for example, silicone, ethylene-propylene, polyurethane, nitrile-butadiene rubber or acetal plastics, or their compounds.

According to an embodiment of the invention the sealing ring is attached to a groove in the first pole piece. The sealing ring is attached to the first pole piece in such a position that the sealing ring stays inside the hole in all positions of the slide.

According to an embodiment of the invention the slide comprises a cap attached on top of the first pole piece for holding the sealing ring in place. The cap may comprise a groove in which the sealing ring is installed. The groove is preferably arranged close to the first pole piece. The groove may be located between the cap and the first pole piece. The cap can be made of magnetic or non-magnetic material.

According to an embodiment of the invention the slide comprises grooves extending in the longitudinal direction of the slide.

An advantage of the magnet according to the invention is that the magnet can be made low because the length of the movement of the slide is small.

Another advantage of the magnet according to the invention is that the magnet does not consume energy when the slide is at either of its two positions. Also the magnet does not have any complex structure for keeping the slide at either of its two positions. In fact, the slide stays in place at both of its two positions with the help of the magnetic field produced by the permanent magnet. Another advantage of the magnet is that its magnetic state can be changed easily. Still another advantage of the magnet is its simple structure that makes the magnet very robust and reliable. Still another advantage of the magnet is that it provides a large holding force with a small size.

Still another advantage of the magnet is that the demagnetization of the permanent magnet can be greatly reduced because the magnetic circuit is closed at the first position of the slide. Still another advantage of the magnet is that its holding force is minimal when the magnet is in the OFF state.

The exemplary embodiments of the invention presented in this text are not interpreted to pose limitations to the applicability of the appended claims. The verb "to comprise" is used in this text as an open limitation that does not exclude the existence of also unrecited features. The features recited in the dependent claims are mutually freely combinable unless otherwise explicitly stated.

### BRIEF DESCRIPTION OF THE DRAWINGS

- Fig. 1: illustrates a cross-sectional view of a magnet according to a first embodiment of the invention,
- fig. 2: illustrates the magnetic field generated by the magnet of fig. 1, when the slide is at the first position,
- fig. 3: illustrates the magnetic field generated by the magnet of fig. 1, when the slide is at the second position,
- fig. 4: illustrates a cross-sectional view of a magnet according to a second embodiment of the invention,
- fig. 5: illustrates the magnetic field generated by the magnet of fig. 4, when the slide is at the first position, and
- fig. 6: illustrates the magnetic field generated by the magnet of fig. 4, when the slide is at the second position.

### DETAILED DESCRIPTION OF THE DRAWINGS

The same reference signs are used of the same or like components in different embodiments.

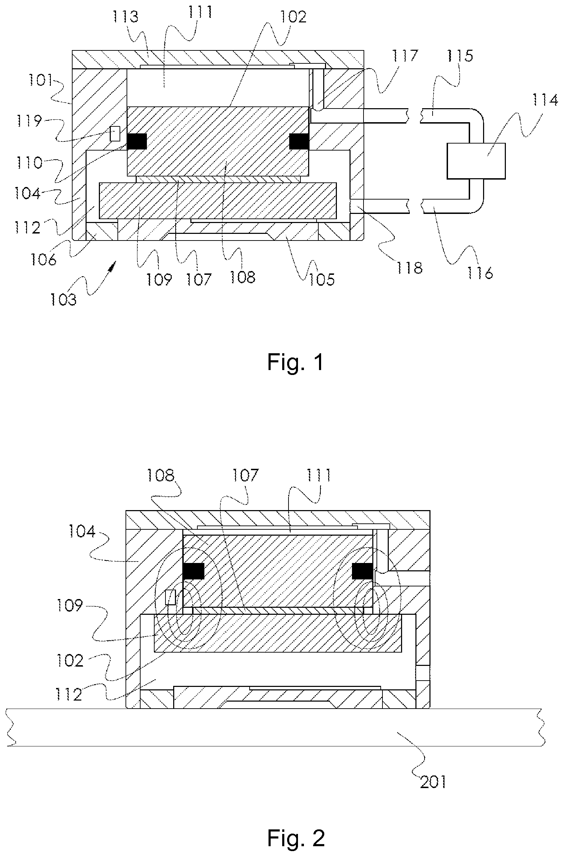

Fig. 1 illustrates a cross-sectional view of a magnet according to a first embodiment of the invention. The magnet comprises a body 101 and a slide 102 that is arranged to be movable relative to the body 101 between a first and a second position. The magnet comprises at its one end an attachment surface 103, which is meant to be arranged in contact with an object to be attached (not shown in fig. 1).

The body 101 comprises a first and a second section 104, 105 that are made of magnetic material for conveying magnetic flux to an object to be attached. The first and the second section 104, 105 are attached together with a third section 106 of the body 101, which third section 106 is made of non-magnetic material. The third section 106 is a ring-shaped section inside which the cylindrical second section 105 is attached.

The slide 102 comprises a permanent magnet 107, and a first and a second cylindrical pole piece 108, 109 that are attached to opposite magnetic pole surfaces of the permanent magnet 107. The slide 102 also comprises a sealing ring 110 that is mounted in a groove in the first pole piece 108.

The first section 104 comprises a cylindrical hole 111 that opens at its first end into a cavity 112 of the body 101, which cavity 112 is defined by the first, the second and the third section 104, 105, 106. A second end of the cylindrical hole 111 is closed by a fourth section 113 of the body 101, which fourth section 113 is made of non-magnetic material.

The slide 102 is movably arranged in the hole 111 in such a manner that part of the first pole piece 108 always stays inside the hole 111, to which part the sealing ring 110 is attached. The second pole piece 109 is directed towards the bottom of the cavity 112, which bottom is defined partly by the second section 105. The diameter of the second pole piece 109 is larger than the diameter of the hole 111. The movement of the slide 102 is mechanically limited by the first and the second section 104, 105 in such a manner that at the first position of the slide 102, the second pole piece 109 engages with the first section 104, and at the second position of the slide 102, the second pole piece 109 engages with the second section 105.

The slide 102 is moved relative to the body 101 by conveying liquid into and out of the hole 111 and the cavity 112. When liquid is supplied into the cavity 112 and exhausted from the hole 111, the slide 102 moves towards the first position. When liquid is supplied into the hole 111 and exhausted from the cavity 112, the slide 102 moves towards the second position.

The liquid is conveyed into and out of the hole 111 and the cavity 112 using a hydraulic system 114 that is coupled via a first and a second pipe 115, 116 to a first and a second conduit 117, 118 that are integrated into the body 101. The first end of the first conduit 117 is arranged in communication with the hole 111 through the fourth section 113 that closes the second end of the hole 111. The first end of the second conduit 118 is arranged in communication with the cavity 112 through the wall of the cavity 112. The position of the slide 102 is determined with a magnetic flux sensor 119 that is arranged inside the first section 104, close to the hole 111.

Fig. 2 illustrates the magnetic field generated by the magnet of fig. 1, when the slide 102 is at the first position. At this position, the first pole piece 108 and the permanent magnet 107 are located inside the hole 111, and the second pole piece 109 is located inside the cavity 112 and in contact with the first section 104. Essentially all of the magnetic flux (illustrated with magnetic field lines) generated by the permanent magnet 107 passes from the first pole piece 108 to the second pole piece 109 through a portion of the first section 104 that surrounds the hole 111 and through a portion of the first section 104 that is in contact with the second pole piece 109. The first section 104 thus short-circuits the magnetic flux generated by the permanent magnet 107. As a result of this, the holding force of the magnet is very small, and therefore the magnet cannot attach to a metal sheet 201.

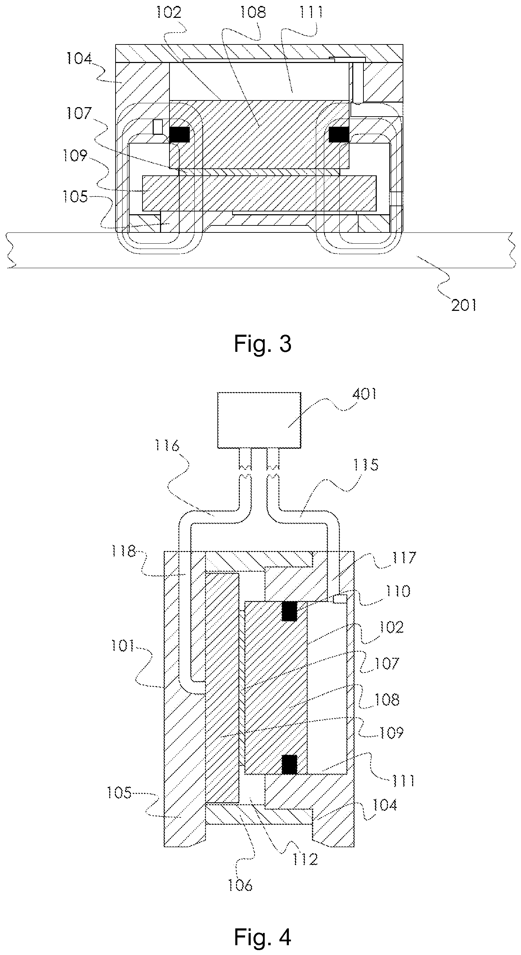

Fig. 3 illustrates the magnetic field generated by the magnet of fig. 1, when the slide 102 is at the second position. At this position, the second pole piece 109 is in contact with the second section 105 and only part of the first pole piece 108 is located inside the hole 111, whereby essentially all of the magnetic flux (illustrated with magnetic field lines) generated by the permanent magnet 107 passes from the first pole piece 108 through the first section 104 to the metal sheet 201 and therefrom through the second section 105 to the second pole piece 109. As a result of this, the holding force of the magnet is large, and therefore the magnet is tightly attached to the metal sheet 201.

Fig. 4 illustrates a cross-sectional view of a magnet according to a second embodiment of the invention. The magnet comprises a slide 102 that is arranged to be movable relative to a body 101 between a first and a second position. The magnet is in an OFF state, when the slide 102 is at the first position, and in an ON state, when the slide 102 is at the second position. Fig. 4 shows the magnet in the ON state.

The slide 102 comprises a permanent magnet 107, and a first and a second cylindrical pole piece 108, 109, which are attached to opposite magnetic pole surfaces of the permanent magnet 107. The slide 102 also comprises a sealing ring 110 that is attached around the first pole piece 108. The body 101 comprises a first and a second section 104, 105, which are made of magnetic material and attached to a third section 106 that is made of non-magnetic material. An object to be attached (not shown in fig. 4) is meant to be in contact with the bottom sides of the first and the second section 104, 105.

The first section 104 comprises a cylindrical hole 111 that opens at its first end into a cavity 112 defined by the first, the second and the third section 104, 105, 106. A second end of the hole is closed by the first section 104. The slide 102 is movably arranged in the hole 111 in such a manner that part of the first pole piece 108 always stays inside the hole 111. The sealing ring 110 is attached to the part that always stays inside the hole 111. The second pole piece 109 is directed towards the bottom of the cavity 112, which bottom is defined by the second section 105. The diameter of the second pole piece 109 is larger than the diameter of the hole 111, so that the second pole piece 109 cannot enter the hole 111. The movement of the slide 102 is mechanically limited by the first and the second section 104, 105 in such a manner that at the first position of the slide 102, the second pole piece 109 is engaged with the first section 104, and at the second position of the slide 102, the second pole piece 109 is engaged with the second section 105. When the slide 102 is at the first position, the first pole piece 108 and the permanent magnet 107 are located inside the hole 111. When the slide 102 is at the second position, only part of the first pole piece 108 is located inside the hole 111. The slide 102 is moved relative to the body 101 by conveying air into and out of an airtight space that is formed by the cavity 112 and the hole 111. When air is supplied into the hole 111 and exhausted from the cavity 112, the slide 102 moves towards the second position. When air is supplied into the cavity 112 and exhausted from the hole 111, the slide 102 moves towards the first position.

The air is conveyed into and out of the hole 111 and the cavity 112 using a pneumatic system 401 that is coupled via a first and a second pipe 115, 116 to a first and a second conduit 117, 118 that are integrated into the body 101. The first end of the first conduit 117 is arranged in communication with the hole 111 through the second end of the hole 111. The first end of the second conduit 118 is arranged in communication with the cavity 112 through the portion of the second section 105 that is in contact with the slide 102, when the slide 102 is at the second position.

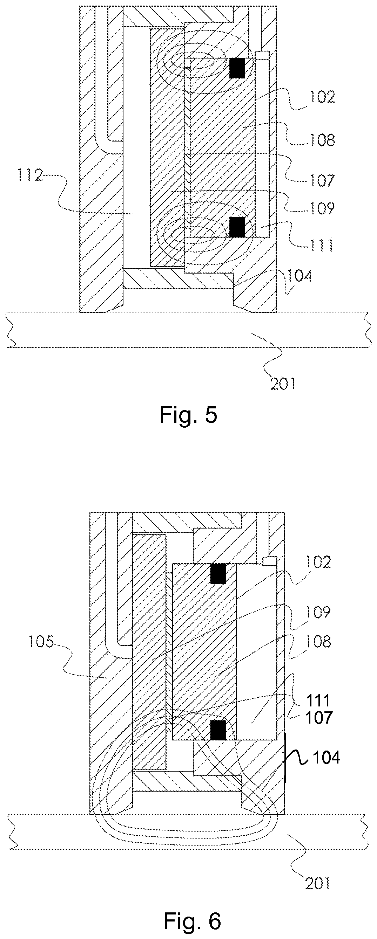

Fig. 5 illustrates the magnetic field generated by the magnet of fig. 4, when the slide 102 is at the first position. The magnetic field is represented by magnetic field lines. At the first position of the slide 102, the first pole piece 108 and the permanent magnet 107 are located inside the hole 111, and the second pole piece 109 is located inside the cavity 112 and in contact with the first section 104. The magnetic flux generated by the permanent magnet 107 passes from the first pole piece 108 to the second pole piece 109 through a portion of the first section 104 that surrounds the hole 111 and through a portion of the first section 104 that is in contact with the second pole piece 109. Because the magnetic flux generated by the permanent magnet 107 is short-circuited by the first section 104, the holding force of the magnet is negligible, and therefore the magnet cannot attach to a metal sheet 201.

Fig. 6 illustrates the magnetic field generated by the magnet of fig. 4, when the slide 102 is at the second position. The magnetic field is represented by magnetic field lines. At the second position of the slide 102, the second pole piece 109 is in contact with the second section 105 and only part of the first pole piece 108 is located inside the hole 111, whereby essentially all of the magnetic flux generated by the permanent magnet 107 passes from the first pole piece 108 through the first section 104 to the metal sheet 201 and therefrom through the second section 105 to the second pole piece 109. The metal sheet 201 that is arranged in contact with both the first and the second section 104, 105 closes the magnetic circuit. The magnet is thus attached to the metal sheet 201.

## Claims

1. A magnet, comprising:
- a body (101) that comprises a first and a second section (104, 105) made of magnetic material for directing magnetic flux to an object to be attached (201), the first and the second section (104, 105) being separated by and attached to a third section (106) of the body (101), which third section (106) is made of non-magnetic material, and
- a slide (102) that comprises a permanent magnet (107), and a first and a second pole piece (108, 109) attached to opposite magnetic pole surfaces of the permanent magnet (107), the slide (102) being arranged to be movable relative to the body (101) between a first and a second position in order to alter the path of the magnetic flux generated by the permanent magnet (107),
wherein
- the first section (104) comprises a hole (111) that opens at its first end into a cavity (112) of the body (101), the bottom of the cavity (112) being defined at least partly by the second section (105), in which hole (111) the slide (102) is movably arranged so that at least part of the first pole piece (108) stays inside the hole (111) and the second pole piece (109) is directed towards the bottom of the cavity (112),
wherein the movement of the slide (102) is limited by the first and the second section (104, 105) in such a manner that at the first position of the slide (102), the second pole piece (109) is in contact with the first section (104), and at the second position of the slide (102), the second pole piece (109) is in contact with the second section (105).

2. The magnet according to claim 1, wherein the diameter of the second pole piece (109) is larger than the diameter of the hole (111).

3. The magnet according to claim 1 or 2, wherein the hole (111) and the first pole piece (108) are cylindrical.

4. The magnet according to any of the preceding claims, wherein the second pole piece (109) is cylindrical.

5. The magnet according to any of the preceding claims, wherein the cavity (112) is cylindrical.

6. The magnet according to any of the preceding claims, wherein the height of the slide (102) is larger than the height of the hole (111).

7. The magnet according to any of the preceding claims, wherein the first section (104) defines the wall of the cavity (112).

8. The magnet according to claim 7, wherein the third section (106) is a hollow cylinder attached inside the first section (104), and the second section (105) is attached inside the third section (106).

9. The magnet according to any of claims 1 to 6, wherein the third section (106) defines the wall of the cavity (112).

10. The magnet according to any of the preceding claims, wherein a second end of the hole (111) is closed by a fourth section (113) of the body (101).

11. The magnet according to any of the preceding claims, wherein the magnet comprises means for transferring a medium (114, 115, 116, 117, 118, 401) into and out of the body (101) in order to move the slide (102).

12. The magnet according to any of the preceding claims, wherein the magnet comprises a coil attached to the body (101) and configured to generate a magnetic force for moving the slide (102) towards the first or the second position depending on the direction of electric current that is supplied to the coil.

13. The magnet according to any of the preceding claims, wherein the magnet comprises a sealing ring (110) installed around the slide (102) or attached to the wall of the hole (111).

14. The magnet according to claim 13, wherein the sealing ring (110) is attached to a groove in the first pole piece (108).

15. The magnet according to claim 13, wherein the slide (102) comprises a cap attached on top of the first pole piece (108) for holding the sealing ring (110) in place.

## Patentansprüche

1. Magnet, der aufweist:
einen Körper (101), der einen ersten und einen zweiten Abschnitt (104, 105) aus magnetischem Material aufweist, um Magnetfluss an einen zu befestigenden Gegenstand (201) zu leiten, wobei der erste und der zweite Abschnitt (104, 105) durch einen dritten Abschnitt (106) des Körpers (101), welcher dritte Abschnitt (106) aus nicht magnetischem Material hergestellt ist, getrennt und daran befestigt sind, und
einen Schlitten (102), der einen Dauermagneten (107) aufweist, und ein erstes und ein zweites Polstück (108, 109), die an gegenüberliegenden Magnetpolflächen des Dauermagneten (107) befestigt sind, wobei der Schlitten (102) dazu ausgelegt ist, bezüglich des Körpers (101) zwischen einer ersten und einer zweiten Position bewegbar zu sein, um den Pfad des von dem Dauermagneten (107) erzeugten Magnetflusses zu ändern, wobei
der erste Abschnitt (104) ein Loch (111) aufweist, das an seinem ersten Ende in einen Hohlraum (112) des Körpers (101) mündet, wobei der Boden des Hohlraums (112) wenigstens teilweise durch den zweiten Abschnitt (105) definiert wird, wobei der Schlitten (102) beweglich in dem Loch (111) angeordnet ist, so dass wenigstens ein Teil des ersten Polstücks (108) in dem Loch (111) verbleibt und das zweite Polstück (109) zum Boden des Hohlraums (112) hin gerichtet ist,
wobei die Bewegung des Schlittens (102) durch den ersten und den zweiten Abschnitt (104, 105) derart eingeschränkt ist, dass an der ersten Position des Schlittens (102) das zweite Polstück (109) mit dem ersten Abschnitt (104) in Kontakt ist und an der zweiten Position des Schlittens (102) das zweite Polstück (109) mit dem zweiten Abschnitt (105) in Kontakt ist.

2. Magnet nach Anspruch 1, wobei der Durchmesser des zweiten Polstücks (109) größer als der Durchmesser des Lochs (111) ist.

3. Magnet nach Anspruch 1 oder 2, wobei das Loch (111) und das erste Polstück (108) zylindrisch sind.

4. Magnet nach einem der vorhergehenden Ansprüche, wobei das zweite Polstück (109) zylindrisch ist.

5. Magnet nach einem der vorhergehenden Ansprüche, wobei der Hohlraum (112) zylindrisch ist.

6. Magnet nach einem der vorhergehenden Ansprüche, wobei die Höhe des Schlittens (102) größer als die Höhe des Lochs (111) ist.

7. Magnet nach einem der vorhergehenden Ansprüche, wobei der erste Abschnitt (104) die Wand des Hohlraums (112) definiert.

8. Magnet nach Anspruch 7, wobei der dritte Abschnitt (106) ein hohler Zylinder ist, der im Inneren des ersten Abschnitts (104) befestigt ist, und der zweite Abschnitt (105) im Inneren des dritten Abschnitts (106) befestigt ist.

9. Magnet nach einem der Ansprüche 1 bis 6, wobei der dritte Abschnitt (106) die Wand des Hohlraums (112) definiert.

10. Magnet nach einem der vorhergehenden Ansprüche, wobei ein zweites Ende des Lochs (111) durch einen vierten Abschnitt (113) des Körpers (101) verschlossen ist.

11. Magnet nach einem der vorhergehenden Ansprüche, wobei der Magnet Mittel zum Übertragen eines Mediums (114, 115, 116, 117, 118, 401) in den und aus dem Körper (101) aufweist, um den Schlitten (102) zu bewegen.

12. Magnet nach einem der vorhergehenden Ansprüche, wobei der Magnet eine Spule aufweist, die an dem Körper (101) befestigt und dazu konfiguriert ist, eine Magnetkraft zu erzeugen, um den Schlitten (102) in Richtung der ersten oder der zweiten Position zu bewegen, in Abhängigkeit von der Richtung elektrischen Stroms, der der Spule zugeführt wird.

13. Magnet nach einem der vorhergehenden Ansprüche, wobei der Magnet einen Dichtring (110) aufweist, der um den Schlitten (102) herum angebracht ist oder an der Wand des Lochs (111) befestigt ist.

14. Magnet nach Anspruch 13, wobei der Dichtring (110) an einer Nut in dem ersten Polstück (108) befestigt ist.

15. Magnet nach Anspruch 13, wobei der Schlitten (102) eine Kappe aufweist, die oben auf dem ersten Polstück (108) befestigt ist, um den Dichtring (110) an Ort und Stelle zu halten.

## Revendications

1. Aimant, comprenant :
- un corps (101) qui comprend une première et une deuxième section (104, 105) constituées d'un matériau magnétique pour diriger un flux magnétique vers un objet à attacher (201), la première et la deuxième section (104, 105) étant séparées par et attachées à une troisième section (106) du corps (101), laquelle troisième section (106) est constituée de matériau non magnétique, et
- une coulisse (102) qui comprend un aimant permanent (107), et une première et une seconde pièce polaire (108, 109) attachées à des surfaces de pôle magnétique opposées de l'aimant permanent (107), la coulisse (102) étant agencée pour pouvoir se déplacer par rapport au corps (101) entre une première et une seconde position afin de modifier le chemin du flux magnétique généré par l'aimant permanent (107),
dans lequel
- la première section (104) comprend un trou (111) qui débouche au niveau de sa première extrémité dans une cavité (112) du corps (101), le fond de la cavité (112) étant défini au moins en partie par la deuxième section (105), trou (111) dans lequel la coulisse (102) est agencée avec faculté de déplacement de sorte qu'au moins une partie de la première pièce polaire (108) reste à l'intérieur du trou (111) et la seconde pièce polaire (109) soit dirigée vers le fond de la cavité (112),
dans lequel le déplacement de la coulisse (102) est limité par la première et la deuxième section (104, 105) de manière à ce qu'à la première position de la coulisse (102), la seconde pièce polaire (109) soit en contact avec la première section (104), et à la seconde position de la coulisse (102), la seconde pièce polaire (109) soit en contact avec la deuxième section (105).

2. Aimant selon la revendication 1, dans lequel le diamètre de la seconde pièce polaire (109) est plus grand que le diamètre du trou (111).

3. Aimant selon la revendication 1 ou 2, dans lequel le trou (111) et la première pièce polaire (108) sont cylindriques.

4. Aimant selon l'une quelconque des revendications précédentes, dans lequel la seconde pièce polaire (109) est cylindrique.

5. Aimant selon l'une quelconque des revendications précédentes, dans lequel la cavité (112) est cylindrique.

6. Aimant selon l'une quelconque des revendications précédentes, dans lequel la hauteur de la coulisse (102) est plus grande que la hauteur du trou (111).

7. Aimant selon l'une quelconque des revendications précédentes, dans lequel la première section (104) définit la paroi de la cavité (112).

8. Aimant selon la revendication 7, dans lequel la troisième section (106) est un cylindre creux attaché à l'intérieur de la première section (104), et la deuxième section (105) est attachée à l'intérieur de la troisième section (106).

9. Aimant selon l'une quelconque des revendications 1 à 6, dans lequel la troisième section (106) définit la paroi de la cavité (112).

10. Aimant selon l'une quelconque des revendications précédentes, dans lequel une seconde extrémité du trou (111) est fermée par une quatrième section (113) du corps (101).

11. Aimant selon l'une quelconque des revendications précédentes, dans lequel l'aimant comprend un moyen de transfert d'un milieu (114, 115, 116, 117, 118, 401) dans et hors du corps (101) afin de déplacer la coulisse (102).

12. Aimant selon l'une quelconque des revendications précédentes, dans lequel
l'aimant comprend une bobine attachée au corps (101) et configurée pour générer une force magnétique afin de déplacer la coulisse (102) vers la première ou la seconde position en fonction de la direction du courant électrique qui est fourni à la bobine.

13. Aimant selon l'une quelconque des revendications précédentes, dans lequel l'aimant comprend un anneau d'étanchéité (110) installé autour de la coulisse (102) ou attaché à la paroi du trou (111).

14. Aimant selon la revendication 13, dans lequel l'anneau d'étanchéité (110) est attaché à une rainure dans la première pièce polaire (108).

15. Aimant selon la revendication 13, dans lequel la coulisse (102) comprend un capuchon attaché en haut de la première pièce polaire (108) afin de tenir l'anneau d'étanchéité (110) en place.
